# EUROPEAN PATENT APPLICATION

(11) **EP 4 818 688 A1**
(43) Date of publication of application: **07.10.2026**
(21) Application number: 25168670.5
(22) Date of filing: 04.04.2025
(51) Int. Cl.: G01N 27/02, A61B 5/00

(54) **IMPEDANCE SENSOR AND METHOD OF USE**

(71) Applicant: Silansys Semiconductor Limited, D14 W6K8 Dublin (IE)
(72) Inventor: Greer, Dr. Nigel, Dublin, D14 W6K8 (IE); Ó hEarcáin, Niall, Dublin, D14 W6K8 (IE)
(74) Representative: FRKelly

(57) **Abstract**

An impedance sensor 1 comprising a detector 3 and a transducer 2. The transducer comprising first and second transducer sensing elements 4, 40. Each sensing element 4, 40 comprises a plurality of electrodes or sensing surfaces for electrical connection. The first transducer sensing element 4 is a sampling element having a variable impedance that varies in a determinable manner in the presence of a known matter. The ratio of the impedance of the sampling element to the impedance of the reference element can be used to identify and/or quantify physical attributes of the known matter. The second transducer sensing element 40 is a reference element having a constant impedance in the presence of the known matter. The transducer sensing elements 4, 40 have a substantially capacitive impedance. The detector comprising a Lock-In Amplifier 5 and an AC signal source 7. The AC signal source is a continuous AC signal operating at a frequency greater than 0 Hz. The Lock-in Amplifier comprising an operational amplifier 6 configured to form a transimpedance amplifier 19 with one of the transducer sensing elements 4, 40. The transimpedance of the transimpedance amplifier 19 is determined by the impedance of one of the transducer sensing elements 4, 40. The AC signal source 7 is configured to deliver current to the output of the operational amplifier 6, via the first and second transducer sensing elements 4, 40, in a continuous manner.

## Description

### Technical Field

This invention relates to the field of impedance sensing technologies, particularly to an impedance sensor and method of measuring impedance characteristics of a known matter using an impedance sensor.

### Background

Impedance and capacitive sensors are known and a variety of detection systems and architectures have been proposed and/or developed. Larry K. Baxter (1996). Capacitive Sensors. John Wiley and Sons details early applications and detectors.

One biomedical application is label-free biosensors that detect biomarkers and generally consist of a transducer, a bioreceptor and a detector. The transducer typically consists of various electrodes such as carbon electrodes, gold electrodes or inter-digitated electrodes. The bioreceptor forms a hybridized conjugate biomarker/bioreceptor that captures and binds the biomarker on the sensing surface and forms a detectable change in capacitance in the transducer. The detector accurately measures the transducer impedance, typically both before and after the molecules are bound. The change in impedance is unique for each target biomarker over the frequency spectrum enabling detection of target RNA or DNA to identify for example respiratory viruses like Covid-19.

Lock-in amplifiers are known and find use in multiple challenging detection applications. An overview of lock-in amplifiers is presented in "Lock-in amplifiers as a platform for weak signal measurements: Development and applications" by Zhang etc in Current Applied Physics 66 (2024) 95-109. An interdigitated capacitor sensed by a transimpedance amplifier (TIA) with resistive feedback and a sigma-delta analog-to-digital (ADC) converter is depicted, and the referenced article "A Microfluidic Device Integrating Impedance Flow Cytometry and Electric Impedance Spectroscopy for High-E□ciency Single-Cell Electrical Property Measurement" by Feng et al, describes the transimpedance circuit design with a feedback resistor of value 100kOhm. A wearable cytometry system based on a discrete off-the-shelf implementation with resistive feedback gain and an 8-bit ADC is also depicted and further described in the reference "Fully integrated wearable impedance cytometry platform on flexible circuit board with online smartphone readout" by Furniturewalla et al. Reference 67, "Multimodal CMOS Biosensor for Microbial Growth Monitoring" by Hosseini et al presents a lock-in amplifier where the transconductance amplifier TIA is based on switched-capacitor architecture.

An overview of capacitor and impedance detectors based on lock-in amplifiers is outlined in "Evolution_of_Lock-In_Amplifier_as_Portable_Sensor_Interface_Platform_A_Review", Kishore and IEEE SENSORS JOURNAL, VOL. 20, NO. 18, SEPTEMBER 15, 2020, in particular section B (Capacitive Sensing Interface), section C (Impedance Sensing) and section E (Nono/Micro-Bio Sensors). Reference 85, "High-density CMOS Microelectrode Array System for Impedance Spectroscopy and Imaging of Biological Cells" by Vijay et al employs a TIA with resistive feedback. Reference 70, "A CMOS Electrochemical Impedance Spectroscopy Biosensor Array for Label-Free Biomolecular Detection" by Manickham et al does not employ a conventional TIA and does not recreate a signal voltage by putting the sensor current through a well-defined impedance - they essentially mirror the sensor current and put it through current-mode mixers.

"A CMOS-Based Capacitive Sensor for Laboratory-On-Chips: Design and Experimental Results" by Ghafar-Zadeh doesn't comprise a TIA and the alternative CBCM interface circuit proposed creates voltage pulses whose amplitude is proportional to the impedance/capacitance being measured. Impedance sensors based on other detector architectures such as switched-capacitor are known.

US 11,796,498 B2 describes the use of a compact, portable biosensor with electrodes covered by a thin passivation protective layer to measure the capacitance of an analyte using standard CMOS manufacturing processing, where the electrodes form the front-end sampling capacitor of a second order switched-capacitor sigma-delta modulator analog-to-digital converter. The resulting sensor appears to be limited in performance due to the inherent thermal noise of the small sampling capacitor Cs, in particular it appears less amenable to high precision (20+ bit) measurement of 10's femtoFarad and lower capacitance values. Furthermore the 1/f flicker noise inherent in CMOS processes further limits performance of the sensor architecture as the charge balancing at the sigma-delta modulator (SDM) ADC is performed at 0Hz, i.e. DC. The resultant sensor is limited to lower sensitivity at the ADC output than the approach set out in the present invention and requires significant digital filtering to increase sensitivity and this requires both additional silicon area (and cost) if done on-chip and additional averaging time.

### Summary of the Invention

It is an object of the present invention to provide an impedance sensor and a method of using the impedance sensor that overcomes the drawbacks of conventional sensors and methods.

According to a first aspect of the present invention there is provided an impedance sensor comprising a detector and a transducer; the transducer comprising first and second transducer sensing elements, wherein each sensing element comprises a plurality of electrodes or sensing surfaces for electrical connection; wherein the first transducer sensing element is a sampling element having a variable impedance that varies in a determinable manner in the presence of a known matter, wherein the ratio of the impedance of the sampling element to the impedance of the reference element can be used to identify and/or quantify physical attributes of the known matter; wherein the second transducer sensing element is a reference element having a constant impedance in the presence of the known matter; the transducer sensing elements having a substantially capacitive impedance; the detector comprising a Lock-In Amplifier and an AC signal source, wherein the AC signal source is a continuous AC signal operating at a frequency greater than 0 Hz; the Lock-in Amplifier comprising an operational amplifier configured to form a transimpedance amplifier with one of the transducer sensing elements; wherein the transimpedance of the transimpedance amplifier is determined by the impedance of one of the transducer sensing elements; wherein the AC signal source is configured to deliver current to the output of the operational amplifier, via the first and second transducer sensing elements, in a continuous manner.

In some embodiments, the impedance of each transducer sensing element may be represented as a resistor and a capacitor in parallel.

In some embodiments, the impedance may be considered substantially capacitive when the magnitude of the capacitive reactance is less than the resistance of the resistor.

In some embodiments, the first transducer sensing element may comprise a capacitor.

In some embodiments, the second transducer sensing element may comprise a capacitor.

In some embodiments, the Lock-In Amplifier may further comprise an Analog-to-Digital, ADC, converter.

In some embodiments, the Lock-In Amplifier may further comprise a digital signal processing circuit.

In some embodiments, the Lock-In Amplifier may further comprise one or more of a buffer amplifier and a low-pass filter.

In some embodiments, the Lock-In Amplifier may further comprise at least one of a four-quadrant mixer and a square-wave signal source.

In some embodiments, the ADC converter may be a sigma delta modulator ADC converter configured to operate in a continuous-time topology.

In some embodiments, the ADC converter may be a sigma delta modulator ADC converter configured to operate in a sampled switched-capacitor topology.

In some embodiments, the sigma delta modulator ADC converter may comprise a chopper front-end circuit.

In some embodiments, the detector may comprise one or more of an autocalibration circuit and non-volatile memory for storing calibration and/or impedance sensor production information.

In some embodiments, the AC signal source may be a sine-wave with programmable frequency and/or amplitude, or a plurality of sinewaves with programmable frequency and/or amplitude.

In some embodiments, the DC input level of the input amplifier may be set by back-to-back diodes connected either between the amplifier input and output terminals, or between the amplifier input and a resistive divider formed by a first resistor and a second resistor, with the resistor divider connected to the amplifier output terminal.

In some embodiments, the first transducer sensing element may comprise a plurality of sensing elements, each of the plurality of sensing elements may have an electrode connected to the AC signal source and another electrode connected to a switch multiplexer for connecting sensing element output to the input of the operational amplifier, and wherein the switch multiplexer may be configured to select which sensing element is connected to the input of the operational amplifier.

In some embodiments, the transducer may comprise a plurality of sensing elements, wherein the Lock-In amplifier may comprise a plurality of amplifiers, and a switch multiplexer may have inputs connected to each amplifier output and the switch multiplexer output may be connected to the buffer input, and wherein switch multiplexer may be configured to select which amplifier is connected to the input of the buffer.

In some embodiments, the transducer sensing elements may be capacitors formed by interdigitated or serpentine electrodes of copper or aluminium covered in a passivation layer.

In some embodiments, the detector may comprise a plurality of Lock-In amplifiers.

In some embodiments, the detector and the transducer may be implemented in an integrated circuit or a plurality of integrated circuits manufactured with a CMOS or BiCMOS semiconductor manufacturing process.

According to a further aspect of the present invention there is provided a method of measuring impedance characteristics of a known matter using an impedance sensor, the method comprising: providing an impedance sensor comprising a detector and a transducer, the transducer having first and second transducer sensing elements, each comprising a plurality of electrodes or sensing surfaces for electrical connection; introducing the known matter to the first transducer sensing element, wherein the first transducer sensing element has a variable impedance that varies in a determinable manner in the presence of the known matter; applying a continuous AC signal from an AC signal source to the transducer sensing elements, the AC signal operating at a frequency greater than 0 Hz; measuring the ratio of the impedance of the first transducer sensing element and the reference element using a Lock-In Amplifier, the Lock-In Amplifier comprising an operational amplifier configured to form a transimpedance amplifier with one of the transducer sensing elements; using the measured impedance ratio to identify and/or quantify physical attributes of the known matter; outputting a measurement result for further analysis or display.

### Brief Description of the Drawings

Embodiments of the present invention will now be described, by way of example only, with reference to the accompany figures in which:
Fig. 1 shows an impedance sensor according to an embodiment of the present invention;
Fig. 2 shows an impedance sensor according to an embodiment of the present invention;
Fig. 3 shows an impedance sensor according to an embodiment of the present invention;
Fig. 4 shows a transimpedance amplifier according to an embodiment of the present invention;
Fig. 5 shows an impedance sensor according to an embodiment of the present invention;
Fig. 6 shows an impedance sensor according to an embodiment of the present invention;
Fig. 7 shows an impedance sensor according to an embodiment of the present invention; and
Fig. 8 shows transducer sensing elements according to an embodiment of the present invention.

### Description of the Embodiments

The invention relates to an impedance sensor that detects and quantifies the impedance between transducers in the form of electrodes or sensing surfaces. Such impedance sensors are employed in a wide variety of expanding applications including industrial, biochemical and biomedical. The impedance sensor is designed to determine certain physical parameters such as the presence of a particular molecule, where the parameter causes a measurable and typically linear variation in the impedance between the transducer surfaces.

A lock-in amplifier comprising a TIA with substantially (i.e. >50%) capacitive feedback impedance operating in continuous time has a thermal noise performance advantage compared with the approaches discussed in the Background and improves the sensor sensitivity and dynamic range. The TIA feedback impedance can be represented as a resistor and a capacitor in parallel and the impedance is substantially capacitive when the magnitude of the capacitor reactance is less than the resistor resistance. Furthermore an ADC designed in particular as a continuous time sigma-delta modulator in contrast to the industry standard switched capacitor sigma-delta modulator can deliver further sensitive and dynamic range performance enhancement.

An object of this invention is to provide an impedance sensor that is compact and portable, and/or more robust, and/or that has greater intrinsic sensitivity at the sigma-delta modulator output in a CMOS or BiCMOS manufacturing process and/or for the same sensor output sensitivity performance this invention requires less digital averaging with the benefits of reducing the silicon die area for digital circuity, enabling the use of lower cost silicon processes, and reducing the processing time.

According to the invention, there is provided a method and architecture of measuring the impedance across the electrodes of a transducer using a detector comprising a lock-in amplifier. The detector lock-in amplifier comprises a front-end transimpedance amplifier (TIA) that operates with a continuous input signal at a frequency above DC to enhance the detector sensitivity. Continuous time operation of the front-end TIA avoids the disadvantage of kT/C noise in a switched-capacitor approach; the lock-in amplifier architecture with a signal tone well above DC avoids the 1/f noise of the TIA operational amplifier; substantially (i.e. >50%) capacitive feedback in the TIA avoids the thermal noise of a feedback resistor.

The term "substantially capacitive impedance" refers to the condition where the impedance of a sensing element is predominantly determined by its capacitive component rather than its resistive component. In practical terms, this occurs when the capacitive reactance, which is the opposition to alternating current (AC) flow presented by the capacitor, is less than the resistance of the resistor in a parallel resistor-capacitor model.

In the context of the impedance sensor, each transducer sensing element can be modelled as a resistor and a capacitor in parallel. The impedance is considered substantially capacitive when the magnitude of the capacitive reactance (Xc = 1/(2πfC), where f is the frequency of the AC signal and C is the capacitance) is less than the resistance (R) of the resistor. This condition ensures that the capacitive behaviour dominates the impedance characteristics of the sensing element, allowing for precise detection and quantification of the known matter based on its interaction with the capacitive component.

This capacitive dominance is particularly advantageous for applications where sensitivity to changes in the dielectric properties of the surrounding environment is crucial. By ensuring that the impedance is substantially capacitive, the sensor can effectively respond to variations in the physical attributes of the known matter, such as changes in permittivity or dielectric constant, which directly affect the capacitance.

The substantially capacitive nature of the impedance allows for enhanced sensitivity and accuracy in detecting and quantifying the known matter, making the impedance sensor highly effective for applications in material characterization, chemical analysis, and other fields requiring precise impedance measurements.

The impedance sensor's design, with its emphasis on substantially capacitive impedance, provides several benefits, including improved sensitivity, accuracy, and reliability in various applications. This design is particularly suited for environments where changes in dielectric properties need to be monitored or controlled.

The lock-in amplifier Analog-to-Digital (ADC) converter is also implemented preferably in a continuous-time sigma delta modulator (SDM) topology for lower noise and higher performance than the standard switched-capacitor SDM topology. As a result, this architecture allows the best resolution to be achieved.

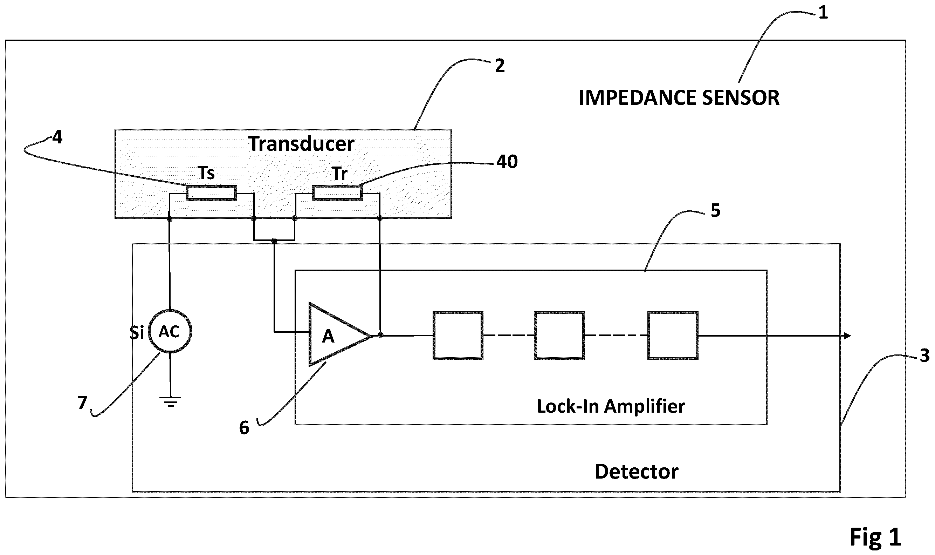

In one embodiment, as depicted in Fig. 1, the impedance sensor 1 comprises a detector 3 and a transducer 2.

In one embodiment, as depicted in Fig. 1, the transducer 2 comprises sensing elements Ts 4 and Tr, with impedances Zs and Zr respectively, and each sensor comprises electrodes or sensing surfaces with electrical connections.

In one embodiment the transducer 2 sensing element Ts 4 is used as a sampling element and its impedance Zs varies in a determinable manner in the presence of a known matter, and the ratio of its impedance Zs to impedance Zr can identify and/or quantify physical attributes of the said matter. In one embodiment the transducer 2 sensing element Tr 40 is used as a reference element and its impedance Zr does not change in the presence of the matter being detected.

In one embodiment, as depicted in Fig. 1, the detector 3 comprises a Lock-In Amplifier 5 and AC signal source Si 7 where Si is a continuous AC signal operating at a frequency greater than 0 Hz (i.e. > DC), and preferably >1kHz.

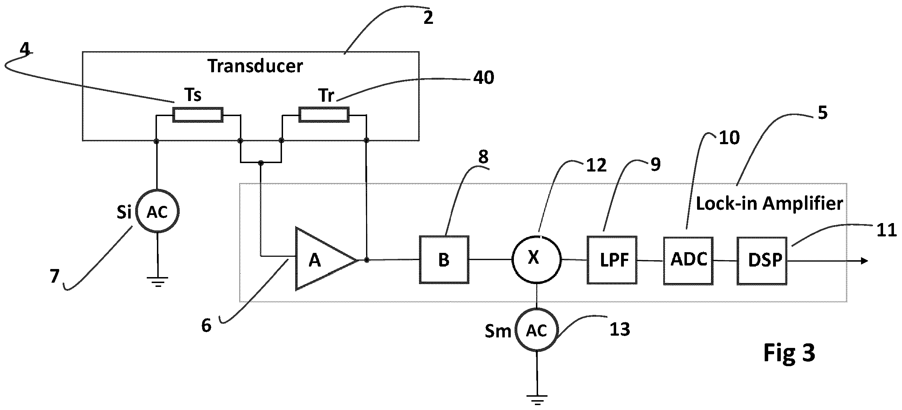

In one embodiment, as depicted in Fig. 3, the detector 3 comprises a Lock-In Amplifier 5 and AC signal sources Si 7 and Sm 13 where Si 7 is a continuous AC signal and Sm 13 is a continuous square-wave signal, and both Si 7 and Sm 13 each operate at a frequency greater than 0 Hz (i.e. > DC), and preferably >1kHz.

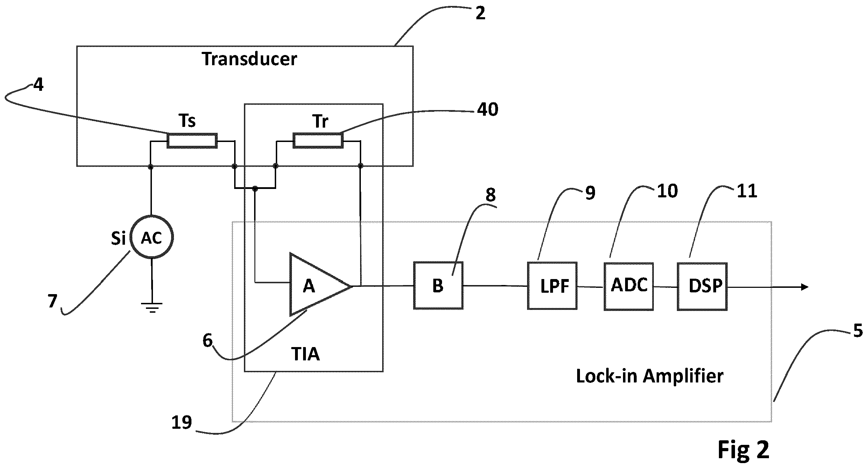

In one embodiment, as depicted in Fig. 2, the Lock-in Amplifier 5 comprises an operational amplifier A 6, where A and sensing element Tr 40 together form a transimpedance amplifier (TIA) 19 and the transimpedance is primarily determined by the impedance Zr of Tr.

In one embodiment the detector 3 AC signal source Si 7 connects to one electrode of transducer 2 sensing element Ts 4 and another electrode of Ts 4 connects to both the input of amplifier A 6 and one electrode of transducer 2 sensing element Tr. Another electrode of Tr 40 connects to the output of amplifier A 6. The AC signal current passing through Si, Ts 4, Tr 40 and the output of A is continuous in time.

In one embodiment the transducer 2 sensing element Tr 40 is formed of the same physical composition as sensing element Ts 4. In one embodiment the reference element Tr 40 comprises one or more replica Ts 4 elements. In one embodiment the transducer 2 sensing element Tr 40 is formed by an on-chip metal-insulator-metal MIM capacitor.

In one embodiment the detector 3 is implemented in an integrated circuit or a plurality of integrated circuits manufactured with a CMOS or BiCMOS semiconductor manufacturing process.

In one embodiment the detector 3 and transducer 2 are both implemented in an integrated circuit or a plurality of integrated circuits manufactured with a CMOS or BiCMOS semiconductor manufacturing process.

In one embodiment, as depicted in Fig. 2, the Lock-In Amplifier (LIA) 5 comprises an amplifier A 6, buffer amplifier B 8, low-pass filter LPF 9, Analog-to-Digital converter ADC 10, and DSP 11 digital signal processing circuit. In this configuration down-conversion of the ADC AC output signal from frequency fᵢ to DC is performed in the DSP 11, simplifying the detector 3 requirements.

In one embodiment, as depicted in Fig. 3, the Lock-In Amplifier (LIA) 5 comprises an amplifier A 6, buffer amplifier B 8, four-quadrant mixer X 12, low-pass filter LPF 9, Analog-to-Digital (A/D) converter ADC 10, and DSP 11 digital signal processing circuit. In this configuration a first stage of down-conversion is performed in the mixer X 12 and if required a final conversion to DC is performed in the DSP 11.

In one embodiment the LIA Analog-to-Digital ADC converter 10 comprises a chopper front-end circuit.

In one embodiment the LIA 5 ADC converter 10 10 is configured as a sigma-delta modulator in a continuous-time topology.

In one embodiment the LIA 5 ADC 10 converter is configured as a sigma-delta modulator in a sampled switched-capacitor topology.

In one embodiment the detector 3 comprises an autocalibration circuit to calibrate the impedance sensor.

In one embodiment the impedance sensor 1 comprises non-volatile memory to store the chip unique identifier and/or other production and/or product related information.

In one embodiment the signal source Si 7 is a sine-wave with programmable frequency and/or amplitude. In one embodiment the signal source Si is generated by a direct-digital-synthesis (DDS) circuit referenced to a low-noise crystal or a frequency reference integrated in the detector 3.

In one embodiment the signal source Si 7 is generated by a PLL referenced to a low-noise crystal or on-chip frequency reference and then passed through a band-pass filter and/or low-pass filter.

In one embodiment the signal source Si 7 is generated by a frequency divider of value 1 or more driven by a low-noise crystal or on-chip frequency reference and/or a band-pass filter and/or low-pass filter.

In one embodiment the signal source Sm 13 is generated by a PLL referenced to a low-noise crystal or a frequency reference integrated into the detector 3.

In one embodiment the signal source Sm 13 is generated by a frequency divider of value 1 or more referenced to a low-noise crystal or on-chip frequency reference.

In one embodiment the signal Si 7 is a plurality of sinewaves of different frequencies.

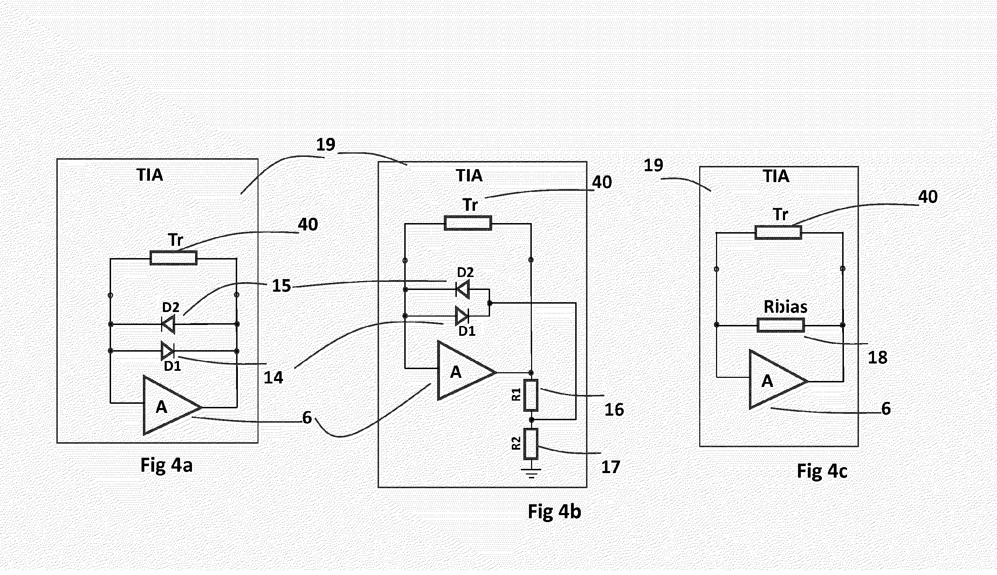

In one embodiment, as depicted in Fig. 4a, the DC input level of input amplifier A 6 in the Lock-In Amplifier 5 is set by back-to-back diodes D1 14 and D2 15 connected between the amplifier A 6 input and output terminals. The requirement to set the DC input level to the TIA without impacting on the TIA transimpedance is a significant challenge and a feedback resistor is not practical when measuring femtofarad level capacitors as an external resistor would introduce significant parasitic capacitances, and an integrated resistor would be too large for a CMOS/BiCMOS detector. A solution based on back-to-back diodes does not impact on the transimpedance, consumes little area for an integrated detector and sets the DC level to an appropriate voltage level.

In one embodiment, as depicted in Fig. 4b, the DC input level of input amplifier A 6 in the Lock-In Amplifier 5 is set by back-to-back diodes D1 14 and D2 15 connected between the amplifier A 6 input and a resistive divider formed by R1 16 and R2 17 and the resistor divider is connected to the amplifier output terminal.

In one embodiment, as depicted in Fig. 4c, the DC input level of input amplifier A 6 in the Lock-In Amplifier 5 is set by a large resistor RBIAS 18 connected between the amplifier input and output terminals, where RBIAS is significantly greater the Zr and Zr dominates the transimpedance of the Lock-In Amplifier 5 front-end TIA 19 formed by amplifier A 6 and transducer 2 reference sensing element Tr 40. The used of this approach is viable for measuring larger capacitances >>100fF.

In one embodiment the transducer 2 comprises a plurality of sensing elements.

In one embodiment the impedance sensor 1 comprises a transducer 2 with sensing elements Ts1, Ts2..TsN 41 each with an electrode connected to signal source Si 7 and another electrode connected to a switch multiplexer SW 20 with inputs IN1..INN and its output connected to the amplifier A input, and where SW 20 is configured to select which sensing element Tsi is connected to the input of amplifier A 6.

In one embodiment the impedance sensor 1 comprises a transducer 2 comprising a plurality of sensing elements Ts1..TsN and Tr1..TrN 42, and the lock-in amplifier 5 contains a plurality of amplifiers A1...AN, and each Tsi is connected to signal source Si 7 and also to an amplifier Ai input, and the corresponding reference element Tri is connected across the input and output of an amplifier Ai, and a switch multiplexer SW 20 with inputs IN1..INN connected to each amplifier Ai output and its output connected to the buffer B 8 input, and where SW 20 is configured to select one amplifier Ai to connect to the input of B.

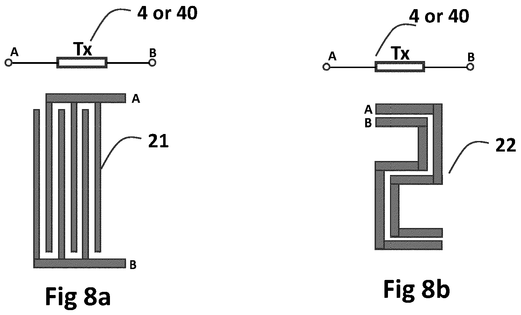

In one embodiment the transducer 2 sensing elements, as depicted in Fig. 8a, are capacitors formed by interdigitated electrodes 21 of aluminium or copper, made by the top metal layer of a CMOS /BiCMOS integrated circuit.

In one embodiment the transducer 2 sensing elements, as depicted in Fig. 8b, are capacitors formed by serpentine metal electrodes 22 of aluminium or copper, made by the top metal layer of a CMOS /BiCMOS integrated circuit.

In one embodiment the transducer 2 sensing elements are covered in a passivation layer of silicon dioxide. In one embodiment the transducer 2 sensing elements Ts 4, Tr 40 are covered in a standard CMOS /BiCMOS passivation layer of silicon nitride on top of a layer of silicon dioxide and reference elements Tr 40 are further covered by a standard CMOS /BiCMOS layer of polyimide

In one embodiment the transducer 2 passivation layer is subjected to a polishing step for planarity of the sensing surface.

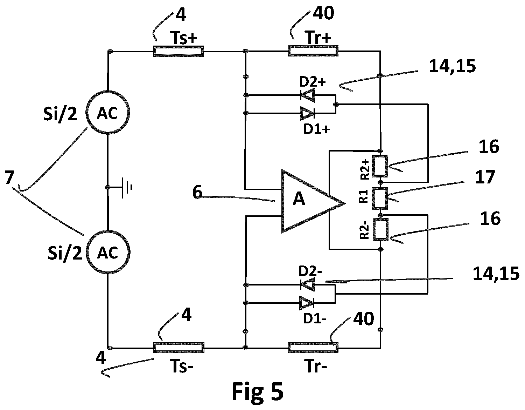

In one embodiment the impedance sensor 1 circuitry and signal sources are implemented in a differential topology as depicted in Fig. 5.

Fig. 1 details one implementation of the impedance sensor 1 comprising a transducer 2, a detector 3 and signal source Si 7. The detector 3 comprises a lock-in amplifier (LIA) 5 and the LIA comprises a front-end amplifier A 6 and optionally other signal processing blocks. The amplifier A 6 together with transducer 2 sensing element Tr 40 form a transimpedance amplifier (TIA) and the transimpedance is primarily determined by the substantially capacitive impedance Zr of element Tr. The impedance Zr of element Tr and Zs of element Ts can each be represented as a resistor and a capacitor in parallel and the impedance is substantially capacitive when the magnitude of the capacitor reactance is less than the resistor resistance. The output AC signal of source Si 7 creates a continuous AC current flow through Ts 4 and Tr 40 where the magnitude of the current is proportional to both the admittance 1/Zs of element Ts 4 and the known amplitude of the S1 AC signal. The output voltage of A is proportional to the ratio of Zr/Zs and the amplitude of the S1 AC signal. The Lock-In Amplifier 5 amplifies and digitises the output of amplifier A 6 and also mixes the AC signal back to DC in one or two stages of mixing to enhance the detector 3 sensitivity in the presence of thermal and 1/f noise.

In one embodiment depicted in Fig. 2 the input to the analog-to-digital converter (ADC 10) is the low-pass filter (LPF 9) output AC signal at frequency Fi, the charge balancing between the reference impedance Tr 40 and sensing element impedance Ts 4 is performed by amplifier A 6 at an elevated frequency to reduce the 1/f noise contribution and the input to the ADC 10 is also at frequency fᵢ to further reduce the 1/f noise contribution. Preferably the frequency fᵢ is set at a frequency >> 1kHz and typically in the range of 10kHz-1MHz. In this embodiment the DSP 11 first implements digital mixing to DC of the AC signal at frequency fᵢ at the ADC 10 output and then performs filtering and averaging of the DC output of the digital mixer. The DSP 11 output represents the ratio between the transducer 2 sensing element admittance 1/Zs and the reference element admittance 1/Zr.

In one embodiment, also depicted by Fig. 2, the input signal source Si 7 generates multiple frequencies f_{i 1}, f_{i 2},... f_{i N} etc simultaneously and the input to the ADC 10 is the LPF 9 output AC signal. In this embodiment the DSP 11 implements an FFT of the SDM output 10 to find the ratio of Zr/Zs at each frequency component f_{i 1}, f_{i 2},... f_{i N} etc of the signal source Si.

In Fig. 3 the impedance sensor 1 also comprises quadrature mixer X 12 and square-wave signal source Sm 13 at frequency fₘ. The input signal source Si 7 frequency fᵢ and the mixer X 12 signal source frequency fₘ are the same (fᵢ = fₘ) and the architecture implements a lock-in amplifier 5 detector 3 where the input to the ADC 10 is a DC signal. The charge balancing between the reference element Tr 40 and sensing element Ts 4 is performed in continuous time by amplifier A 6 at a frequency fᵢ well above DC to reduce the amplifier's 1/f noise contribution. Preferably the frequencies fᵢ and fₘ are set at a frequency >1kHz and typically in the range of 10kHz-10MHz. In this embodiment the DSP 11 performs filtering and averaging of the DC output of the ADC 10 and its output represents the ratio between the transducer 2 sensing element admittance 1/Zs and the reference element admittance 1/Zr.

In one embodiment as depicted in Fig. 3 the input signal source frequency fᵢ and the mixer signal source frequency fₘ are set to different frequencies and the architecture implements a lock-in amplifier 5 based detector 3 where the input to the ADC 10 is an AC signal at a frequency of fᵢ - fₘ, the charge balancing between the reference and sensor capacitor is performed by amplifier A 6 at a frequency well above DC to reduce the 1/f noise contribution and furthermore the input to the ADC 10 is also at an elevated frequency to reduce the ADC 10 1/f noise contribution. Preferably the frequencies fᵢ and fₘ are set at a frequency >> 1kHz and typically in the range of 10kHz-1MHz with a difference frequency fᵢ - fₘ also >1kHz. In this embodiment the DSP 11 first implements digital mixing to DC of the AC signal at frequency fᵢ - fₘ at the ADC 10 output and then performs filtering and averaging of the DC output of the digital mixer. The DSP 11 output represents the ratio between the transducer 2 sensing element admittance 1/Zs and the reference element admittance 1/Zr.

In one embodiment the ADC 10 converter is implemented as a second-order continuous-time sigma-delta modulator (CT-SDM) with a front-end chopping circuit. The CT-SDM embodiment is a particularly low-noise implementation avoiding the kT/C noise of a more typical switched-capacitor implementation. In the case of DC or low-frequency input signals the CT-SDM uses chopping in its first stage to remove 1/f and DC offsets. The CT-SDM will preferably include an auto-calibration circuit and/or programmable non-volatile memory to tune the CT-SDM time-constants and other parameters for manufacturing process variations.

The industry default approach to designing the sigma-delta modulator is to use a second-order switched-capacitor sigma-delta modulator as it is easier to design and less sensitive to CMOS process variation. In theory, for a given time constant and integration capacitor, the sampling capacitor of a switched capacitor sigma-delta modulator (SC-SDM) has the same level of noise as the equivalent resistor. In practice, the CT-SDM would tend to have lower noise and result in improved impedance sensor 1 performance for a number of reasons as follows:
- It is possible to implement very high impedances with switched capacitors, even 100s of Mohms, which is good for area and IDD, but not for noise. On the other hand, polysilicon resistors with a reasonable area will be much lower in impedance and hence less noisy.
- Although the kT/C of the input sampling capacitor is in theory the same as the noise of an equivalent resistor, there is another kT/C noise source as the sampling caps will also alias down the thermal noise of the amplifier A 6, which can be significant, whereas the CT-SDM only sees the in-band noise of the amplifier A 6.
- The CT-SDM has built-in anti-aliasing, so it provides better rejection of high frequency noise that may be generated by preceding blocks in the signal path.
- In a SC-SDM, the noise of the amplifier A 6 will also be sampled by the switched capacitors of the feedback digital-to-analog converter (DAC), as well as the input sampling capacitors. Whereas in a CT-SDM the feedback DAC can be implemented with switched current sources, whose high output impedance makes them insensitive to the amplifier noise.

In one embodiment the ADC 10 converter is implemented as a second-order switched-capacitor sigma-delta modulator (SC-SDM). In the case of DC or low-frequency input signals the SC-DSM preferably includes chopping in its first stage, to remove 1/f and DC offsets.

In one embodiment, as depicted in Fig. 4a, the transimpedance amplifier TIA 19 comprises of amplifier A, transducer 2 reference element Tr 40 and back-to-back diodes D1 14 and D2 15 that set the amplifier A input DC common mode voltage while maintaining the very high (i.e. >>100's MOhm 10⁶ or GOhm 10⁹ Ohm) resistance required to set the TIA 19 high pass corner << fᵢ.

In another embodiment as depicted in Fig. 4b the back-to-back diodes D1 14 and D2 15 are connected to a resistive attenuator R1 16 and R2 17 at the amplifier A 6 output to enable a larger signal swing at the amplifier output while maintaining the very high resistance across the amplifier terminals and also requiring little silicon area. Fig. 4a and Fig. 4b avoid the use of a resistive feedback across the amplifier A 6 terminals and result in a lower noise front-end and higher sensitivity, and the transimpedance is determined by the transducer 2 element Tr. The amplifier A 6 is preferably a high gain, low noise, low distortion, operational amplifier.

In one embodiment as depicted in Fig. 5 the TIA 19, amplifier A 6, sensor elements 4, 40, back-to-back diodes D1 14 and D2 15 and resistive attenuator R1 16 and R2 17, together with input source Si 7, are implemented in a differential topology typical of an integrated circuit implementation.
Fig. 4c depicts the TIA 19 is implemented as an amplifier A with feedback resistor RBIAS setting the DC level at the amplifier input and impedance Zr primarily setting the TIA 19 transimpedance, and RBIAS >> Zr at the frequency fᵢ. The feedback resistor may be integrated in CMOS/BiCMOS technology or connected external to the detector 3. In one embodiment the resistor is a CMOS/BiCMOS polysilicon type resistor. In one embodiment the resistor is a long MOS device in weak inversion. In one embodiment the resistor is a long MOS device in weak inversion with its VGS voltage programmable to vary the resistance. In one embodiment the VGS voltage is programmed by a DAC.

The design target would preferably be for system noise performance to be limited by the TIA 19. The TIA 19 operational amplifier A 6 preferably has an input noise of <100nV/rtHz, an input capacitance of similar order of magnitude to the equivalent input capacitance Zs and a gain-bandwidth product of at least 100*fᵢ, and a DC gain of >80dB, to provide a virtual earth at the input terminal between Zs and Zr.

The buffer B 8 has low input noise, low distortion and a low output impedance and isolates the sensitive front-end amplifier A 6 from the noisy mixer switching transients. In one embodiment it is implemented as an instrumentation amplifier. In one embodiment it has a fixed gain or attenuation to increase or decrease the signal at the mixer and/or LPF 9 input. In one embodiment it has a programmable gain or attenuation. In one embodiment, as depicted in Fig. 3, when the mixing is performed only in the digital domain the buffer B 8 is connected directly to the LPF 9. In one embodiment B is implemented by two unity gain buffer amplifiers.

The low noise, low distortion LPF 9 cut-off frequency is preferably set to be higher than the ADC 10 input frequency and lower than the mixer frequencies fᵢ and fₘ in Fig. 2. In Fig. 3 the LPF 9 cut-off frequency is preferably set to be higher than the SDM 10 input frequency fᵢ and significantly lower than the SDM 10 sampling frequency.

The signals Si 7 and Sm 13 at frequencies fᵢ and fₘ respectively are generated so as to have very low jitter at frequencies close to their respective carrier frequency. Higher frequency jitter will be significantly filtered at the output and is less of a concern. The signal source Si 7 is preferably a sinusoidal waveform. The signal source Sm 13 is preferably a square-wave waveform. Frequencies fₘ and fᵢ are preferably derived from a low jitter oscillator reference using dividers and/or a PLL or PLLs.

In one embodiment the oscillator reference is an external crystal reference. In one embodiment the oscillator reference is an on-chip oscillator. In one embodiment the frequencies fₘ and fᵢ can be flexibly programmed to improve sensitivity and robustness in the presence of interferer signals and/or their harmonics. In one embodiment the signal source Si 7 is a square-wave generator filtered by a band-pass filter and the filter is centred at the desired carrier frequency fᵢ to remove unwanted harmonics.

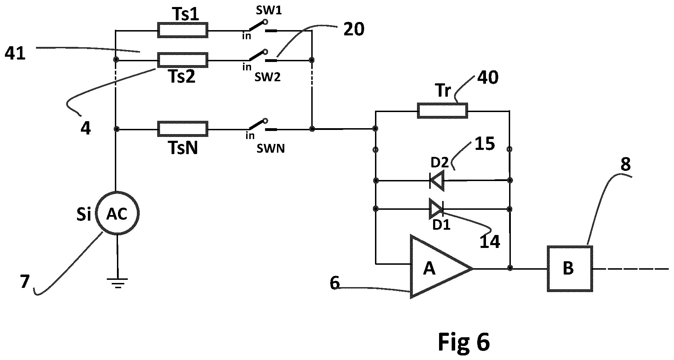

In one embodiment as depicted in Fig. 6 the transducer 2 contains a plurality of sensing elements Ts1, Ts2...TsN and switches SW1, SW2...SWN, and the switches are controlled so that only one sensing element is connected to the amplifier A 6 in the lock-in amplifier 5. This approach requires little extra circuitry while enabling the measurement of a plurality of sensing elements with one lock-in amplifier.

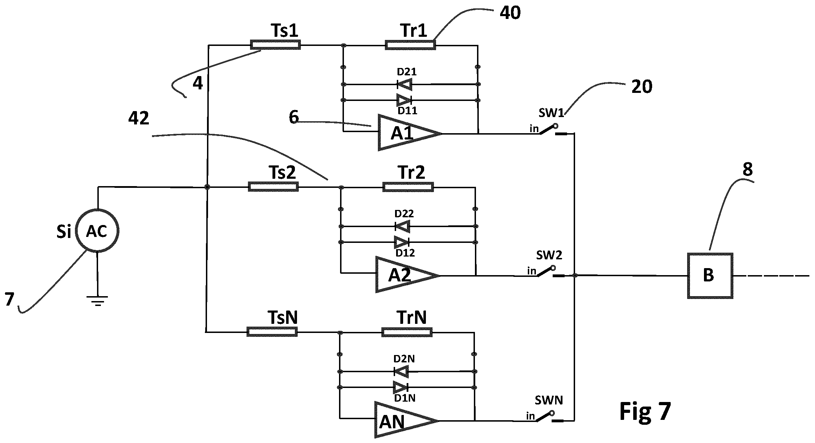

In one embodiment as depicted in Fig. 7 the transducer 2 contains a plurality of sensing elements Ts1, Ts2...TsN; Tr1, Tr2...TrN ; amplifiers A1, A2...AN and switches SW1, SW2...SWN, and the switches are controlled so that only one sensing element is connected to the common buffer B 8 in the lock-in amplifier 5. In other embodiments the buffer B 8 could also be replicated and the switches connected between buffers B1, B2...BN and the LPF 9 block. This approach is preferable for measurement of femtofarad or smaller capacitances as it avoids adding switches and routing with unwanted capacitances at the sensitive nodes between sampling and reference transducer elements, at the expense of both additional detector circuitry and calibration complexity.

In one embodiment as depicted in Figure 8a the transductor sensor elements are formed by interdigitated top level metal electrodes 21 in a CMOS/BiCMOS integrated circuit. In one embodiment as depicted in Figure 8b the transductor sensor elements are formed by top-level serpentine metal electrodes 22 in a CMOS/BiCMOS integrated circuit.

In one embodiment the transducer 2 sensing elements Ts 4, Tr 40 are covered in a CMOS /BiCMOS passivation layer of silicon nitride on top of a layer of silicon dioxide and reference elements Tr 40 are further covered by a standard CMOS /BiCMOS layer of polyimide. Sensing elements Ts 4 do not have a polyimide covering and the presence of a known matter on the sensing surface may change the fringing capacitance between the element electrodes. Polishing of the nitride passivation, a CMOS/BiCMOS step commonly employed in optical sensors, can improve the planarity and sensing element reproducibility.

In one embodiment the amplitude of the signal Si 7 is set to a reference voltage appropriate for the CMOS/BiCMOS semiconductor technology, preferably 0.5V-2.5V, to maximise noise performance while minimising distortion. In one embodiment the amplitude of the signal Si 7 at fᵢ or multiple frequencies component f_{i 1}, f_{i 2},... f_{i N} etc is set by a DAC to enable fine tuning of the amplitude over a wide range to enable characterization of non-linear capacitances over a range of signal amplitudes. Non-volatile memory is used to store data such as sensor calibration, ADC calibration, unique chip identifier, production date and other product specific information relevant to quality control and/or inventory management of the sensor.

An autocalibration circuit can automatically tune the impedance sensor for semiconductor manufacturing process variation, parasitic capacitances and/or variations in transducer sensing elements. Ideally transducer elements Ts and Tr would have a known fixed ratio, typically 1, before the element to be sensed by Ts is placed on the Ts sensing surfaces. Autocalibration performs measurements that enable determination of the actual ratio in advance and enable a correction coefficient to be determined and stored on-chip or in the system memory. Further-more adjustment of the resistor or capacitor components in a continuous-time sigma delta modulator is often required to optimise performance by calibration to a fixed frequency reference using a successive approximation algorithm.

A key challenge in the design of a lock-in amplifier based detectors, whether based on discrete components but especially for integrated CMOS or BiCMOS implementations, is the elimination of crosstalk between the various reference frequencies and their harmonics, and the 'wanted' signal being detected that can be >80dB lower. In particular the front-end amplifier circuits must be sufficiently shielded from crosstalk in the substrate, metal or circuit board connections, CMOS/BiCMOS electrical static discharge protection components, power and bias circuitry to achieve in the order of 100dB dynamic range.

In one embodiment, the amplitude of the input signal source Si 7 is proportional to the reference voltage of the ADC 10, to achieve a ratiometric measurement, which is independent of any low frequency noise present on the reference voltage.

The invention is not limited to the embodiments as described and may vary in detail and/or construction. For example while Figures 1-4 and 6-7 depict single-ended circuit topologies the differential equivalent, as illustrated in Fig. 5 for the front-end TIA (19) and signal source Si (7), may be employed in an integrated circuit implementation. As a further example the positions of sensing elements Ts 4 and Tr 40 may be interchanged with Ts 4 implementing a variable TIA 19 feedback impedance and Tr 40 implementing a constant input impedance.

The following sections compares the performance of three capacitive sensors measuring capacitors of 23fF and 0.4fF:
a) Switched-capacitor capacitive sensor
b) Lock-in amplifier with a resistive feedback transimpedance amplifier
c) Using the proposed invention with continuous time TIA with a capacitive feedback and a continuous time SDM ADC.

### a) Switched-capacitor capacitive sensor

**Table 1** shows the resolution as a function of capacitor kT/C noise for a configuration using the approach in 'US-11796498-B2 Capacitive sensor and method of use' and with the sigma-delta modulator SDM 1/f flicker noise estimated at 3uV/rtHz for 23fF and 22.7uV/rtHz for 0.4fF. The configuration used 1MSamples/sec sampling at the SDM ADC input, 60Samples/sec at the output and 1V reference voltage. The resulting resolution is ~15.5bits for 23fF and ~12.6bits for 0.4fF.

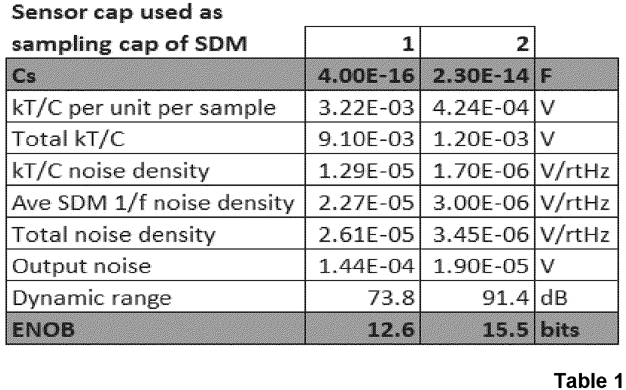

### b) Capacitive sensor Lock-in amplifier with resistive feedback transimpedance amplifier

### Lock-in amplifier with

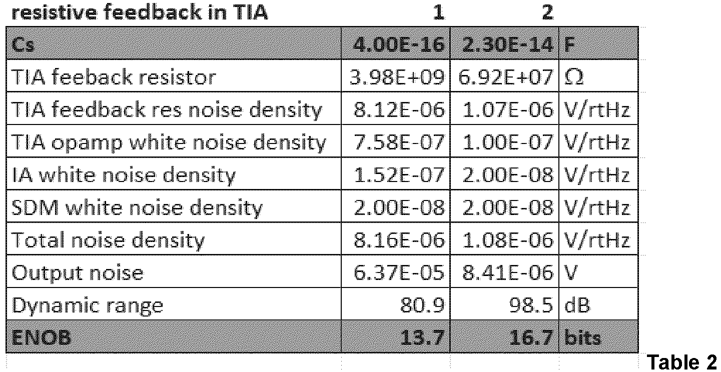

**Table 2** shows the performance of a lock-in amplifier based on a TIA with resistive feedback, measuring the same 0.4fF and 23fF capacitances. In the table the resistor values are calculated to have the same impedance as Cs with fᵢ = 100kHz. The resulting resolution is ~16.7bits for 23fF and ~13.7bits for 0.4fF.

### c) Impedance sensor proposed in the invention

Table 3 shows the resolution for a 23fF and also a 0.4fF sensing capacitor as a function of the white noise levels of the continuous-time circuits for a configuration as depicted in Fig. 2 where fᵢ = fₘ and the preferred case where the SDM ADC is a continuous-time sigma-delta modulator SDM. The resulting resolution is approximately 20.0bits for 23fF and 17.1bits for 0.4fF. In this case the SDM ADC device sizes are not constrained by the magnitude of Zs and the resultant 1/f noise is less, and is removed by the front-end chopper.

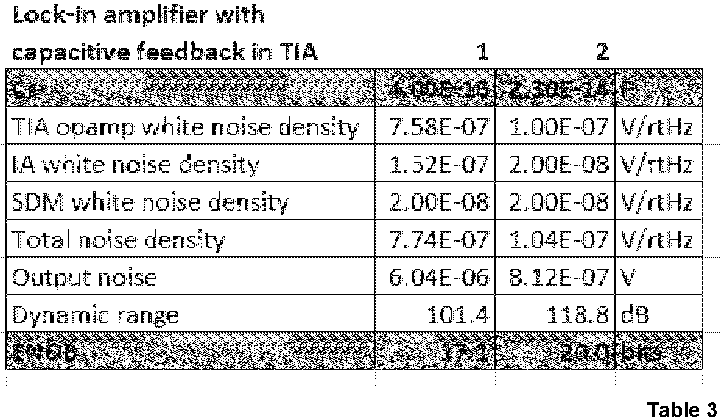

It will be appreciated that there is a significant improvement in performance using the invention compared with that detailed in a) above for a switched-capacitor approach and the improvement is in the order of 4.5bits of ENOB or 27dB of Dynamic Range. The improvement in performance of the invention compared with that detailed in b) for a resistive feedback TIA approach is in the order of 3.3bits of ENOB or 20dB of Dynamic Range and is also significant.

The invention is not limited to the embodiment(s) described herein but can be amended or modified without departing from the scope of the present invention.

## Claims

1. An impedance sensor (1) comprising a detector (3) and a transducer (2);
the transducer comprising first and second transducer sensing elements (4, 40), wherein each sensing element (4, 40) comprises a plurality of electrodes or sensing surfaces for electrical connection;
wherein the first transducer sensing element (4) is a sampling element having a variable impedance that varies in a determinable manner in the presence of a known matter, wherein the ratio of the impedance of the sampling element to the impedance of the reference element can be used to identify and/or quantify physical attributes of the known matter;
wherein the second transducer sensing element (40) is a reference element having a constant impedance in the presence of the known matter;
wherein the transducer sensing elements (4, 40) have a substantially capacitive impedance;
the detector comprising a Lock-In Amplifier (5) and an AC signal source (7), wherein the AC signal source is a continuous AC signal operating at a frequency greater than 0 Hz;
the Lock-in Amplifier comprising an operational amplifier (6) configured to form a transimpedance amplifier (19) with one of the transducer sensing elements (4, 40); wherein the transimpedance of the transimpedance amplifier (19) is determined by the impedance of one of the transducer sensing elements (4, 40);
wherein the AC signal source (7) is configured to deliver current to the output of the operational amplifier (6), via the first and second transducer sensing elements (4, 40), in a continuous manner.

2. The impedance sensor according to claim 1, wherein the impedance of each transducer sensing element is represented as a resistor and a capacitor in parallel.

3. The impedance sensor according to claim 2, wherein the impedance is considered substantially capacitive when the magnitude of the capacitive reactance is less than the resistance of the resistor.

4. The impedance sensor (1) of any of claims 1 to 3, wherein the first transducer sensing element (4) comprises a capacitor.

5. The impedance sensor (1) of any of claims 1 to 4, wherein the second transducer sensing element (40) comprises a capacitor.

6. The impedance sensor (1) of any of claims 1 to 5, wherein the Lock-In Amplifier (5) further comprises an Analog-to-Digital, ADC, converter (10).

7. The impedance sensor (1) of any preceding claim, wherein the Lock-In Amplifier (5) further comprises a digital signal processing circuit (11).

8. The impedance sensor (1) of any preceding claim, wherein the Lock-In Amplifier (5) further comprises one or more of a buffer amplifier (8) and a low-pass filter (9).

9. The impedance sensor (1) of any preceding claim, wherein the Lock-In Amplifier (5) further comprises one or more of a four-quadrant mixer (12) and a square-wave signal source (13).

10. The impedance sensor (1) of any of claims 6 to 9, wherein the ADC converter (10) is a sigma delta modulator ADC converter configured to operate in a continuous-time topology.

11. The impedance sensor (1) of any of claims 6 to 9, wherein the ADC converter (10) is a sigma delta modulator ADC converter configured to operate in a sampled switched-capacitor topology.

12. The impedance sensor (1) of claim 10 or claim 11, wherein the sigma delta modulator ADC converter comprises a chopper front-end circuit.

13. The impedance sensor (1) of any preceding claim, wherein the detector (3) comprises one or more of an autocalibration circuit and non-volatile memory for storing calibration and/or impedance sensor production information.

14. The impedance sensor (1) of any preceding claim, wherein the AC signal source (7) is a sine-wave with programmable frequency and/or amplitude, or a plurality of sinewaves with programmable frequency and/or amplitude.

15. The impedance sensor of any preceding claim, wherein the DC input level of the input amplifier (6) is set by back-to-back diodes (14, 15) connected either between the amplifier (6) input and output terminals, or between the amplifier (6) input and a resistive divider formed by a first resistor (16) and a second resistor (17), with the resistor divider connected to the amplifier (6) output terminal.

16. The impedance sensor (1) of any preceding claim, wherein the first transducer sensing element (4) comprises a plurality of sensing elements (Ts1, Ts2..TsN), each of the plurality of sensing elements having an electrode connected to the AC signal source (7) and another electrode connected to a switch multiplexer (20) for connecting sensing element output to the input of the operational amplifier (6), and wherein the switch multiplexer (20) is configured to select which sensing element (Tsi) is connected to the input of the operational amplifier (6).

17. The impedance sensor (1) of any preceding claim, wherein the transducer (2) comprises a plurality of sensing elements (Ts1..TsN and Tr1..TrN), wherein the Lock-In amplifier comprises a plurality of amplifiers (A1...AN), and a switch multiplexer (20) having inputs (IN1..INN) connected to each amplifier (Ai) output and the switch multiplexer (20) output is connected to the buffer (8) input, and wherein switch multiplexer (20) is configured to select which amplifier (Ai) is connected to the input of the buffer (8).

18. The impedance sensor (1) of any preceding claim, wherein the transducer sensing elements are capacitors formed by interdigitated (21) or serpentine (22) electrodes of copper or aluminium covered in a passivation layer.

19. The impedance sensor (1) of any preceding claim, wherein the detector comprises a plurality of Lock-In amplifiers.

20. The impedance sensor (1) of any preceding claim, wherein the detector (3) and the transducer (2) are implemented in an integrated circuit or a plurality of integrated circuits manufactured with a CMOS or BiCMOS semiconductor manufacturing process.

21. A method of measuring impedance characteristics of a known matter using an impedance sensor, the method comprising:
providing an impedance sensor comprising a detector and a transducer, the transducer having first and second transducer sensing elements, each comprising a plurality of electrodes or sensing surfaces for electrical connection;
introducing the known matter to the first transducer sensing element, wherein the first transducer sensing element has a variable impedance that varies in a determinable manner in the presence of the known matter;
applying a continuous AC signal from an AC signal source to the transducer sensing elements, the AC signal operating at a frequency greater than 0 Hz;
measuring the ratio of the impedance of the first transducer sensing element and the reference element using a Lock-In Amplifier, the Lock-In Amplifier comprising an operational amplifier configured to form a transimpedance amplifier with one of the transducer sensing elements;
using the measured impedance ratio to identify and/or quantify physical attributes of the known matter;
outputting a measurement result for further analysis or display.
